# EUROPEAN PATENT APPLICATION

(11) **EP 4 607 211 A1**
(43) Date of publication of application: **27.08.2025**
(21) Application number: 25159875.1
(22) Date of filing: 25.02.2025
(51) Int. Cl.: G01R 31/08, G01R 31/42, G01R 31/52, H02M 1/00

(54) **CONVERTER AND DETECTION METHOD THEREOF**

(30) Priority: 26.02.2024 CN 202410213051
(71) Applicant: Huawei Digital Power Technologies Co., Ltd., Shenzhen, Guangdong 518043 (CN)
(72) Inventor: XIN, Defeng, Shenzhen, 518129 (CN); FU, Mingxiao, Shenzhen, 518129 (CN); MA, Zheng, Shenzhen, 518129 (CN)
(74) Representative: Epping - Hermann - Fischer

(57) **Abstract**

This application provides a power converter and a detection method thereof. The power converter includes a power conversion circuit and a control circuit. Three branches are formed between three phase wires of the power conversion circuit and an N wire, and the three branches form current imbalance branches. The power conversion circuit includes an inverter circuit and a filter circuit, and the three branches are located behind the filter circuit. When the N wire is normally connected, a voltage of the N wire does not deviate from a center point when clamped by a voltage of a power grid. Therefore, differences between every two of three phase voltages are less than a specified threshold. When the control circuit determines that the differences are less than the specified threshold, it is considered that the N wire is normal, and the inverter circuit can be started or run normally. When the N wire is faulty, a voltage of the N wire deviates from a center point due to the current imbalance branches. Therefore, differences between every two of the three phase voltages are greater than a specified threshold. When the control circuit determines that a difference is greater than the specified threshold, it is considered that the N wire is abnormally connected, and an N-wire fault alarm signal is output.

## Description

### TECHNICAL FIELD

The present invention relates to the field of new energy technologies, and relates to a power converter and a detection method thereof.

### BACKGROUND

A power converter is connected to a three-phase alternating current power grid on an alternating current side. Three-phase alternating current power grids are classified into a three-phase three-wire alternating current power grid and a three-phase four-wire alternating current power grid. (1) A neutral wire is not led out from the three-phase three-wire alternating current power grid. In other words, only three wires, namely, three live wires: a phase-A wire, a phase-B wire, and a phase-C wire, are led out from the alternating current power grid. (2) A neutral wire is led out from the three-phase four-wire alternating current power grid. In other words, four wires are led out from the alternating current power grid, and include the neutral wire (N wire) and three live wires: a phase-A wire, a phase-B wire, and a phase-C wire.

When the power converter is used in the three-phase four-wire alternating current power grid, it needs to be detected whether there is a missed connection between the neutral wire in the alternating current power grid and the power converter or whether the neutral wire is disconnected, so that when the neutral wire is faulty, an alarm can be reported to a user or running of the power converter can be stopped according to a scenario requirement. A current detection manner cannot accurately distinguish between a sampling loop fault and a missed connection or a disconnection fault of the neutral wire. Therefore, accuracy of detecting a neutral wire fault is low.

### SUMMARY

This application provides a power converter and a detection method thereof, to improve accuracy of detecting a neutral line fault.

According to a first aspect, this application provides a power converter, including a power conversion circuit and a control circuit. The power conversion circuit includes an inverter circuit and a filter circuit. The inverter circuit is configured to: convert an input direct current into an alternating current, and output the alternating current to an alternating current power grid. The filter circuit is configured to filter the alternating current output by the inverter circuit, so that the alternating current transmitted to an alternating current bus meets an on-grid requirement. Three branches are formed between three phase wires of the power conversion circuit and a neutral wire, and the three branches are located behind the filter circuit. The three branches include a first branch and a second branch. The first branch includes at least one of a capacitor, a resistor, and an inductor. A component like a switch or a relay may be further disposed on the first branch. A current of the first branch is different from a current of the second branch, so that the three branches form current imbalance branches. Specifically, if currents flowing through at least two of the three branches are set to be unequal, it may be considered that the three branches are current imbalance branches. Components such as the resistor, the capacitor, and the inductor are used to construct the current imbalance branches between the N wire and a phase-A wire, a phase-B wire, and a phase-C wire. When the N wire is missed from connection, a voltage of the N wire deviates from a center point due to the current imbalance branches, and therefore three phase voltages are unequal. The three phase voltages are respectively voltages between the three phase wires and the neutral wire. When the N wire is normally connected, the voltage of the N wire is clamped by a voltage of a power grid, and the N wire cannot deviate from the center point through the current imbalance branches. Therefore, differences between every two of the three phase voltages are not large. In this case, after determining the three phase voltages AN, BN, and CN, the control circuit may calculate the differences between every two of the three phase voltages AN, BN, and CN, that is, a difference between the phase voltage AN and the phase voltage BN, a difference between the phase voltage AN and the phase voltage CN, and a difference between the phase voltage BN and the phase voltage CN. When the N wire is normally connected, a voltage of the N wire does not deviate from a center point when clamped by a voltage of a power grid. Therefore, the differences between every two of the three phase voltages are less than a specified threshold. When the control circuit determines that the differences are less than the specified threshold, it is considered that the N wire is normal, and the power converter can be started or run normally. When the N wire is faulty, a voltage of the N wire deviates from a center point due to the current imbalance branches. Therefore, the differences between every two of the three phase voltages are greater than a specified threshold. When the control circuit determines that a difference is greater than the specified threshold, it is considered that the N wire is abnormally connected (including a missed connection or a wire disconnection), and an N-wire fault alarm signal is output. In addition, the N-wire fault alarm signal may indicate the power converter to send an alarm, or may be used to report an N-wire fault to a user.

In some embodiments of this application, to ensure compatibility of a three-phase three-wire alternating current power grid and a three-phase four-wire alternating current power grid, in other words, to enable the power converter provided in this application to be used in both the three-phase three-wire alternating current power grid and the three-phase four-wire alternating current power grid, the control circuit may specifically sample one phase voltage and two wire voltages of the power conversion circuit. Because any two wire voltages and any one phase voltage are known, the other wire voltage and the other two phase voltages may be obtained through calculation. In this way, the control circuit may obtain the three phase voltages through calculation based on the one phase voltage and the two wire voltages that are obtained through sampling. The wire voltage is a voltage between two phase wires.

In some other embodiments of this application, to ensure compatibility of a three-phase three-wire alternating current power grid and a three-phase four-wire alternating current power grid, in other words, to enable the power converter provided in this application to be used in both the three-phase three-wire alternating current power grid and the three-phase four-wire alternating current power grid, the control circuit may alternatively sample two phase voltages of the power conversion circuit and one wire voltage and that cannot be obtained through calculation based on vectors of the two phase voltages. Because any two phase voltages and one wire voltage that cannot be obtained through calculation based on vectors of the two phase voltages are known, the other phase voltage and the other two wire voltages may be obtained through calculation. In this way, the control circuit may obtain the three phase voltages through calculation based on the two phase voltages and the one wire voltage that are obtained through sampling.

In some embodiments of this application, when outputting the N-wire fault alarm signal, the control circuit may further control the power converter to shut down, to prevent an electric shock risk caused by the missed connection of the N wire.

In some embodiments of this application, to construct the current imbalance branches, the second branch includes at least one of a capacitor, a resistor, and an inductor, and a component like a switch or a relay may be further disposed on the second branch, or no component may be disposed on the second branch.

In some embodiments of this application, to construct the current imbalance branches, the three branches further include a third branch, and a current of the third branch may be different from a current of the first branch, and/or the current of the third branch may be different from the current of the second branch.

In some embodiments of this application, to construct the current imbalance branches, the third branch includes at least one of a capacitor, a resistor, and an inductor, and a component like a switch or a relay may be further disposed on the third branch, or no component may be disposed on the third branch.

In some embodiments of this application, to construct the current imbalance branches, the first branch, the second branch, and the third branch each may include the resistor, and resistance values of the resistors included in the first branch, the second branch, and the third branch may be different. The three branches may further be used for discharging a capacitor inside the power converter during shutdown.

In some embodiments of this application, the power conversion circuit may further include a surge protective device. The surge protective device is configured to prevent surges caused by lightning strikes when a cable that is in the alternating current power grid and that is connected to the wiring terminal is an overhead cable. The three branches may be located between the filter circuit and the surge protective device.

According to a second aspect, this application provides a detection method for a power converter, applied to the power converter provided in the first aspect. The detection method may be performed by a control circuit in the power converter. The method provided in this embodiment of this application specifically includes the following steps: obtaining differences between every two of three phase voltages output by the power converter, where the phase voltage is a voltage between one phase wire and a neutral wire; and outputting a neutral-wire fault alarm signal when any one of the differences is greater than a specified threshold.

In some embodiments of this application, to ensure compatibility of a three-phase three-wire alternating current power grid and a three-phase four-wire alternating current power grid, in other words, to enable the power converter provided in this application to be used in both the three-phase three-wire alternating current power grid and the three-phase four-wire alternating current power grid, the detection method may further include: obtaining two phase voltages and one wire voltage that cannot be obtained through calculation based on vectors of the two phase voltages, and obtaining the three phase voltages through calculation based on the two phase voltages and the one wire voltage.

In some other embodiments of this application, to ensure compatibility of a three-phase three-wire alternating current power grid and a three-phase four-wire alternating current power grid, in other words, to enable the power converter provided in this application to be used in both the three-phase three-wire alternating current power grid and the three-phase four-wire alternating current power grid, the detection method may further include: obtaining one phase voltage and two wire voltages of the power converter, and obtaining three phase voltages through calculation based on the one phase voltage and the two wire voltages.

For technical effects that can be achieved by any possible design in the second aspect, refer to the technical effects that can be achieved by any possible design in the first aspect. Details are not described herein again. These aspects or other aspects in this application are clearer and more comprehensible in descriptions of the following embodiments.

### BRIEF DESCRIPTION OF DRAWINGS

FIG. 1 is a vector diagram of a voltage of a three-phase four-wire power grid;
FIG. 2 is a diagram of a framework structure of a photovoltaic system;
FIG. 3 is a diagram of a circuit structure of a power conversion apparatus;
FIG. 4 is a diagram of a circuit structure of a power converter according to an embodiment of this application;
FIG. 5a to FIG. 5l each are a diagram of a circuit structure of three branches in a power converter according to an embodiment of this application;
FIG. 6 is a diagram of a specific circuit structure of three branches in a power converter according to an embodiment of this application; and
FIG. 7 is a schematic flowchart of a detection method for a power converter according to an embodiment of this application.

### DESCRIPTION OF EMBODIMENTS

To make a person of ordinary skill in the art understand technical solutions in this application better, the following clearly and completely describes the technical solutions in embodiments of this application with reference to the accompanying drawings.

It should be noted that, in this specification, claims, and accompanying drawings of this application, the terms "first", "second", and the like are intended to distinguish similar objects but do not necessarily indicate a specific order or sequence. It should be understood that data used in such a way is interchangeable in a proper circumstance, so that embodiments of this application described herein can be implemented in an order other than the order illustrated or described herein. Implementations described in the following example embodiments do not represent all implementations consistent with this application. On the contrary, the implementations are merely examples of apparatuses and methods that are described in the appended claims in detail and that are consistent with some aspects of this application.

The following describes some terms in embodiments of this application, to facilitate understanding of a person skilled in the art.
(1) An inverter is a power conversion apparatus that converts a direct current of a photovoltaic module, a battery, or the like into an alternating current (usually a sine wave of 220 V and 50 Hz) with constant frequency and voltage or frequency and voltage adjustment.
(2) A three-phase four-wire system is a wiring mode in which three live wires and one neutral wire are included.
(3) An N wire is a neutral wire in a three-phase four-wire alternating current power grid. A neutral wire in a three-phase four-wire system is the N wire. In a normal case, absolute voltage values between the N wire and the other three live wires are the same.
(4) A missed connection means that a wire is not in reliable contact with a wiring terminal. In this application, the missed connection means that a wire of an alternating current power grid is not connected to a wiring terminal of a power converter due to a disconnected cable of the alternating current power grid or a man-made omission.
(5) A wire voltage is a voltage between every two live wires in a phase-A lead wire, a phase-B lead wire, and a phase-C lead wire, namely, three live wires, in a three-phase alternating current power grid. A wire voltage AB is a difference between a phase-A voltage and a phase-B voltage, a wire voltage BC is a difference between the phase-B voltage and a phase-C voltage, and a wire voltage CA is a difference between the phase-C voltage and the phase-A voltage.
(6) A phase voltage is a voltage between an N wire, namely, a neural wire, and each of a phase-A lead wire, a phase-B lead wire, and a phase-C lead wire, namely, three live wires, in a three-phase alternating current power grid. A phase voltage AN is a difference between a phase-A voltage and an N-wire voltage, a phase voltage BN is a difference between a phase-B voltage and the N-wire voltage, and a phase voltage CN is a difference between a phase-C voltage and the N-wire voltage.

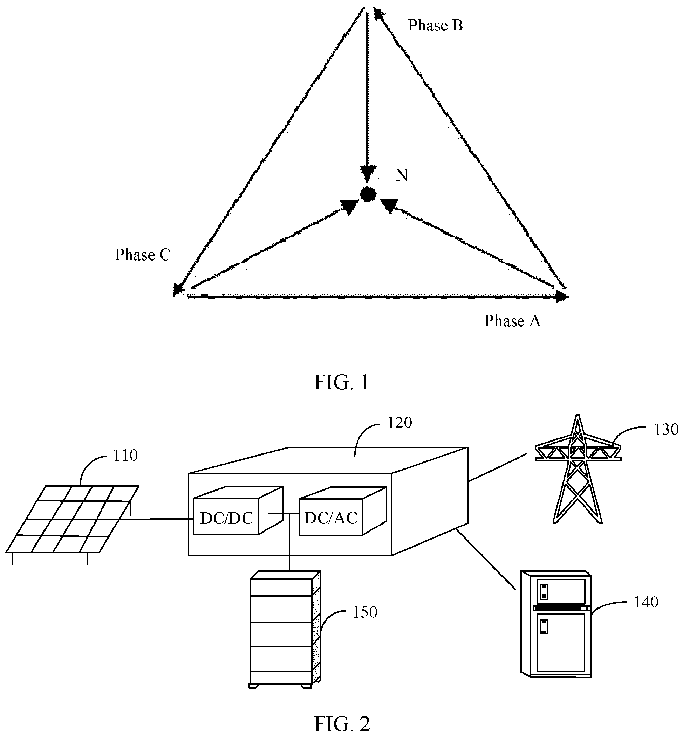

As shown in FIG. 1, in a voltage vector relationship of a three-phase four-wire alternating current power grid, phase differences between a wire voltage AB, a wire voltage BC, and a wire voltage CA are 120°, a vector sum of the wire voltage AB, the wire voltage BC, and the wire voltage CA is zero, phase differences between a phase voltage AN, a phase voltage BN, and a phase voltage CN are 120°, and a vector sum of the phase voltage AN, the phase voltage BN, and the phase voltage CN is zero. A vector difference between the phase voltage AN and the phase voltage BN is a vector of the wire voltage AB, a vector difference between the phase voltage BN and the phase voltage CN is a vector of the wire voltage BC, and a vector difference between the phase voltage CN and the phase voltage AN is a vector of the wire voltage CA. Therefore, the following relationships may be obtained.
(1) If the three phase voltages AN, BN, and CN are known, the wire voltages AB, BC, and CA can be obtained through calculation.
(2) If any two wire voltages and any one phase voltage are known, the other wire voltage and the other two phase voltages can be obtained through calculation.
(3) If any two phase voltages and one wire voltage that cannot be obtained through calculation based on vectors of the two phase voltages are known, the other phase voltage and the other two wire voltages can be obtained through calculation.
(4) If the three wire voltages AB, BC, and CA are known, the three phase voltages AN, BN, and CN cannot be obtained through calculation.

In the conventional technology, a voltage of a power grid is usually sampled and whether the N wire is connected is determined in the following manners.
(1) The three phase voltages AN, BN, and CN are sampled from voltages of an alternating current power grid, and whether the N wire is missed from connection may be determined by determining a relationship between the three phase voltages. In this manner, the power converter can be used in only a three-phase four-wire alternating current power grid, and cannot be compatible with a three-phase three-wire alternating current power grid.
(2) The three wire voltages AB, BC, and CA are sampled from voltages of an alternating current power grid. Because the N wire is not sampled, whether the N wire is missed from connection cannot be determined. To ensure compatibility of the three-phase three-wire alternating current power grid and the three-phase four-wire alternating current power grid, one phase voltage needs to be added for sampling, in other words, there are four voltages for sampling in total. A large quantity of voltages for sampling results in increases in a quantity of resistor-capacitors and a quantity of operational amplifiers that are required for voltage sampling. In addition, adding one voltage sampling channel to a sampling chip also increases costs.
(3) Two phase voltages and one wire voltage that cannot be obtained through calculation based on vectors of the two phase voltages are sampled from voltages of an alternating current power grid, or one phase voltage and two wire voltages are sampled. If a sampling loop is faulty or the N wire is missed from connection, no corresponding voltage is sampled from each of the phase voltages. The phase voltage AN, the phase voltage BN, and the phase voltage CN may be obtained through calculation based on vectors of the voltages obtained through sampling. However, whether the sampling loop is faulty or the N wire is missed from connection cannot be accurately determined.

In view of this, embodiments of this application provide a power converter and a detection method thereof, to accurately determine whether there is a missed connection or a wire disconnection between the power converter and an N wire. To make the objectives, technical solutions, and advantages of this application clearer, the following further describes this application in detail with reference to the accompanying drawings.

First, an application scenario of the power converter provided in embodiments of this application is described. The power converter provided in embodiments of this application can be used in a scenario like a photovoltaic plant, an energy storage plant, or a photovoltaic and energy storage plant.

FIG. 2 is an example diagram of a framework structure of a photovoltaic system. As shown in FIG. 2, the photovoltaic system includes a photovoltaic array 110, a power conversion apparatus 120, an energy storage apparatus 150, and a power grid 130/external load 140. The power conversion apparatus 120 may integrate a DC/DC conversion circuit and a DC/AC conversion circuit, and the energy storage apparatus 150 may be located between the DC/DC conversion circuit and the DC/AC conversion circuit. The DC/DC conversion circuit performs boost or buck conversion on electric energy generated by the photovoltaic array 110, and then converted electric energy may be used for charging the energy storage apparatus 150. The electric energy generated by the photovoltaic array 110 may be further transmitted to the alternating current power grid 130/external load 140 through the DC/DC conversion circuit and the DC/AC conversion circuit. When the electric energy generated by the photovoltaic array 110 is insufficient to supply power to the alternating current power grid 130/external load 140, electric energy stored in the energy storage apparatus 150 may be transmitted to the alternating current power grid 130/external load 140 through the DC/AC conversion circuit in the power conversion apparatus 120. In addition, the energy storage apparatus 150 may further receive power supply from the alternating current power grid 130, an alternating current output by the alternating current power grid 130 is converted into a direct current through the DC/AC conversion circuit, and the direct current is transmitted to the energy storage apparatus 150, for charging the energy storage apparatus 150.

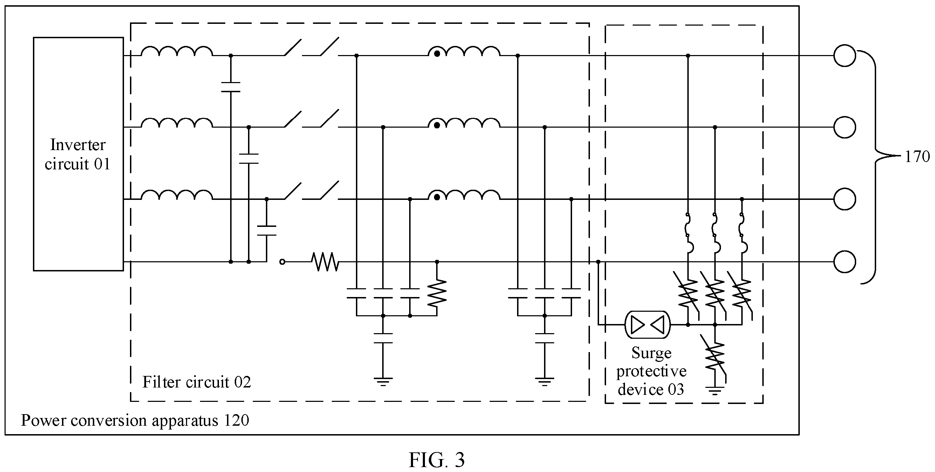

FIG. 3 is an example diagram of a circuit structure of a power conversion apparatus. As shown in FIG. 3, during actual application, a photovoltaic system usually includes a plurality of power conversion apparatuses 120 that are connected in parallel. One power conversion apparatus 120 may be connected to a group of photovoltaic modules in the photovoltaic array 110, and is configured to: convert a direct current output by the photovoltaic module, and then transmit an alternating current to the alternating current power grid 130. One power conversion apparatus 120 may also be connected to the energy storage apparatus 150, and is configured to: convert a direct current output by the energy storage apparatus 150, and then transmit an alternating current to the alternating current power grid 130. Therefore, the photovoltaic array 110 and the energy storage apparatus 150 may be collectively referred to as a direct current power supply. Each power conversion apparatus 120 includes an inverter circuit 01 and a filter circuit 02. An input end of the inverter circuit 01 is connected to the direct current power supply through a direct current bus, an output end of the inverter circuit 01 is connected to the filter circuit 02, and the filter circuit 02 is connected to the alternating current power grid 130 through an alternating current bus 170. The inverter circuit 01 is configured to convert a direct current input by the photovoltaic module (or the energy storage apparatus 150) into an alternating current, and output the alternating current to the alternating current power grid 130. The filter circuit 02 is configured to filter the alternating current output by the inverter circuit 01, so that the alternating current transmitted to the alternating current power grid 130 meets an on-grid requirement. When the direct current power supply connected to the inverter circuit 01 is the photovoltaic module, the power conversion apparatus 120 may be specifically a photovoltaic inverter. When the direct current power supply connected to the inverter circuit 01 is a battery cluster, the power conversion apparatus 120 may be specifically a power conversion system. As shown in FIG. 3, the inverter circuit 01 in the power conversion apparatus 120 may be a three-phase four-wire inverter circuit, for example, a neutral point clamped (NPC) inverter circuit. The filter circuit 02 may have a plurality of structures, for example, may be an LCL filter. The filter circuit 02 may specifically include an inductor, a capacitor, and an inductor that are sequentially connected to the alternating current bus 170. The capacitor mainly performs a filtering function. One end of the capacitor may be connected to the alternating current bus 170, and the other end of the capacitor may be connected to an N wire. The alternating current bus 170 specifically includes three wires L 1, L2, and L3 that correspond to a phase A, a phase B, and a phase C, and a surge protective device 03 is usually further connected to a wiring terminal side of each wire. This prevents surges caused by lightning strikes when a cable that is in the alternating current power grid and that is connected to the wiring terminal is an overhead cable.

Currently, in the foregoing several manners of determining whether the N wire in the power conversion apparatus 120 is connected to the alternating current power grid, the wire voltage AB, the wire voltage BC, and the wire voltage CA that are formed between the three wires L 1, L2, and L3, and corresponding voltages in the phase voltage AN, the phase voltage BN, and the phase voltage CN that are formed between the N wire and the three wires L1, L2, and L3 are sampled. In the existing manners, whether the sampling loop is faulty or the N wire is missed from connection cannot be accurately determined

In view of this, according to the power converter and the detection method thereof provided in embodiments of this application, current imbalance branches are constructed between three phase wires and an N wire by using at least one of a capacitor, a resistor, and an inductor, and whether differences between every two of three phase voltages are greater than a specified threshold is determined. In this way, whether the N wire is missed from connection or is disconnected can be accurately detected, so that detection accuracy is improved.

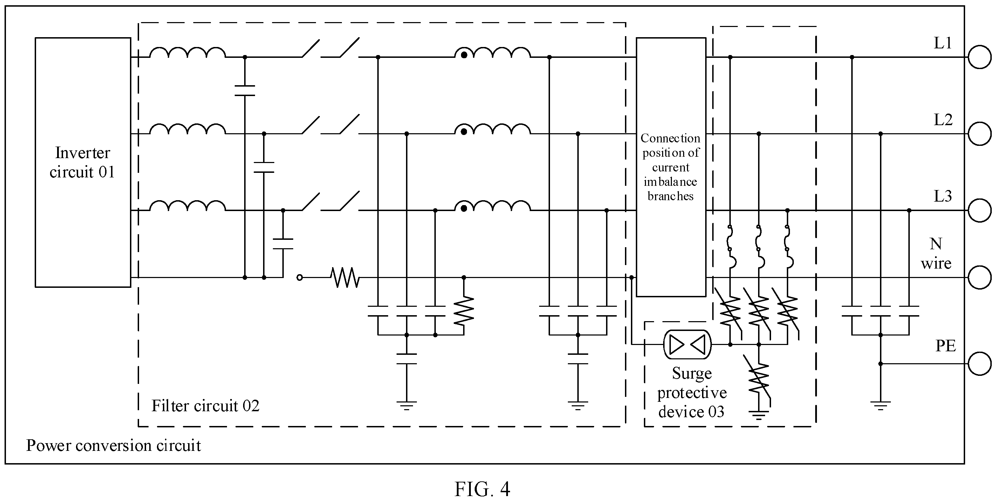

FIG. 4 is an example diagram of a circuit structure of a power converter according to an embodiment of this application. As shown in FIG. 4, in this application, the power converter may include a power conversion circuit and a control circuit. The power conversion circuit includes an inverter circuit 01 and a filter circuit 02. An input end of the inverter circuit 01 is connected to the direct current power supply through a direct current bus, an output end of the inverter circuit 01 is connected to the filter circuit 02, and the filter circuit 02 is connected to the alternating current power grid through an alternating current bus. The inverter circuit 01 is configured to convert an input direct current into an alternating current, and output the alternating current to the alternating current bus. The filter circuit 02 is configured to filter the alternating current output by the inverter circuit 01, so that the alternating current transmitted to the alternating current bus meets an on-grid requirement. When the direct current power supply connected to the inverter circuit 01 is the photovoltaic module, the power conversion circuit may be specifically a photovoltaic inverter. When the direct current power supply connected to the inverter circuit 01 is a battery cluster, the power conversion circuit may be specifically a power conversion system. For example, the inverter circuit 01 may be a neutral point clamped (NPC) inverter circuit. The filter circuit 02 may have a plurality of structures, for example, may be an LCL filter. The filter circuit 02 may specifically include an inductor, a capacitor, and an inductor that are sequentially connected to the alternating current bus. The capacitor mainly performs a filtering function. One end of the capacitor may be connected to the alternating current bus, and the other end of the capacitor may be connected to an N wire. The alternating current bus specifically includes three wires L 1, L2, and L3 that correspond to a phase A, a phase B, and a phase C, and a surge protective device 03 is usually further connected to a wiring terminal side of each wire. This prevents surges caused by lightning strikes when a cable that is in the alternating current power grid and that is connected to the wiring terminal is an overhead cable. Three branches may be formed between the N wire and the three phase wires L1, L2, and L3 The three branches are disposed behind the filter circuit 02, and the three branches may be specifically disposed between the filter circuit 02 and the surge protective device 03.

In this application, the three branches are set as current imbalance branches, and the phase-A wire, the phase-B wire, and the phase-C wire are connected to the N wire through the current imbalance branches. If currents flowing through at least two of the three branches are unequal, it may be considered that the three branches are the current imbalance branches. That is, the three branches may specifically include a first branch, a second branch, and a third branch, and a current of the first branch is different from a current of the second branch, and a current of the third branch may be the same as that of the first branch and different from that of the second branch, or a current of the third branch may be the same as that of the second branch and different from that of the first branch, or a current of the third branch may be different from that of the first branch and different from that of the second branch. In the foregoing several cases, the three branches are the current imbalance branches. The first branch, the second branch, and the third branch each may be any one of the branch between the phase-A wire L1 and the N wire, the branch between the phase-B wire L2 and the N wire, and the branch between the phase-C wire L3 and the N wire. The following provides descriptions by using an example in which the first branch is the branch between the phase-A wire L1 and the N wire, the second branch is the branch between the phase-B wire L2 and the N wire, and the third branch is the branch between the phase-C wire L3 and the N wire.

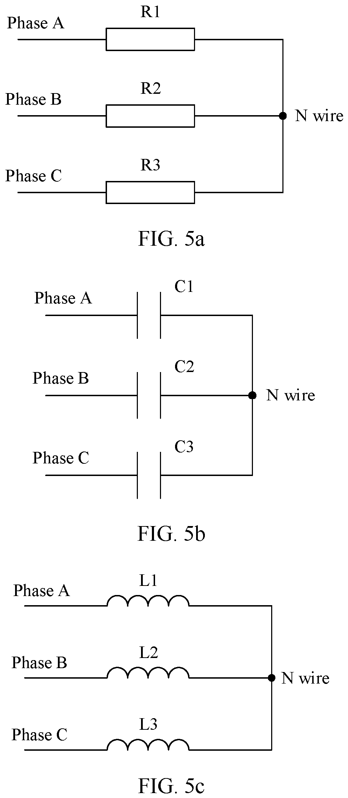

FIG. 5a to FIG. 5l each are an example diagram of a circuit structure of the three branches in the power converter according to this embodiment of this application.

As shown in FIG. 5a to FIG. 5l, at least one of a capacitor, a resistor, and an inductor may be disposed on the first branch, and a component like a switch or a relay may be further disposed on the first branch. Alternatively, at least one of a capacitor, a resistor, and an inductor may be disposed on the second branch, and a component like a switch or a relay may be further disposed on the second branch, or no component may be disposed on the second branch. Alternatively, at least one of a capacitor, a resistor, and an inductor may be disposed on the third branch, and a component like a switch or a relay may be further disposed on the third branch, or no component may be disposed on the third branch.

In some embodiments of this application, as shown in FIG. 5a to FIG. 5c, components are disposed on all the three branches, and component types may be the same. For example, as shown in FIG. 5a, resistors with different resistance values may be disposed on the first branch, the second branch, and the third branch. As shown in FIG. 5b, capacitors with different capacitance values may alternatively be disposed on the first branch, the second branch, and the third branch. As shown in FIG. 5c, inductors with different inductance values may alternatively be disposed on the first branch, the second branch, and the third branch. When resistors or inductors are disposed on all the three branches, the three branches may further be used for discharging a capacitor inside the inverter circuit during shutdown.

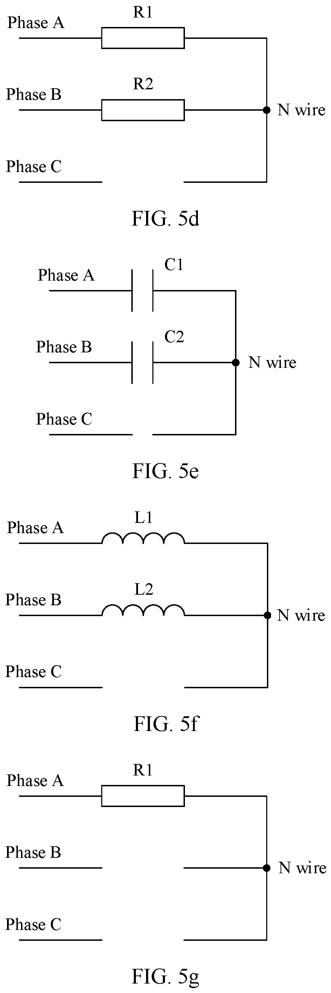

In some other embodiments of this application, as shown in FIG. 5d to FIG. 5f, components are disposed on any two of the three branches, and component types are the same. For example, as shown in FIG. 5d, resistors with different resistance values may be disposed on the first branch and the second branch, and no component is disposed on the third branch, in other words, it may be considered that the third branch is disposed as disconnected. As shown in FIG. 5e, capacitors with different capacitance values may alternatively be disposed on the first branch and the second branch, and no component is disposed on the third branch, in other words, it may be considered that the third branch is disposed as disconnected. As shown in FIG. 5f, inductors with different inductance values may alternatively be disposed on the first branch and the second branch, and no component is disposed on the third branch, in other words, it may be considered that the third branch is disposed as disconnected.

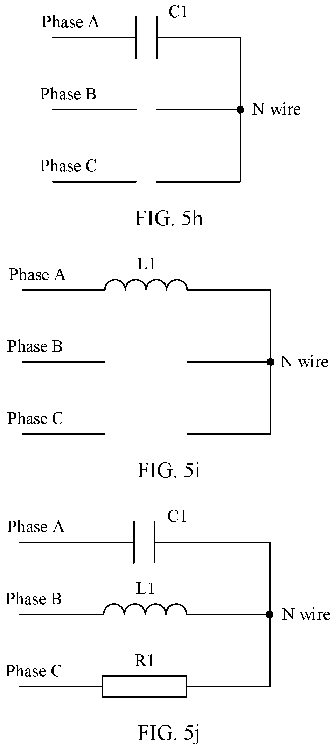

In some other embodiments of this application, as shown in FIG. 5g to FIG. 5i, a component is disposed on any one of the three branches, and no component is disposed on the other two branches. For example, as shown in FIG. 5g, a resistor is disposed on the first branch, and no component is disposed on the second branch and the third branch, in other words, it may be considered that the second branch and the third branch are disposed as disconnected. As shown in FIG. 5h, a capacitor is disposed on the first branch, and no component is disposed on the second branch and the third branch, in other words, it may be considered that the second branch and the third branch are disposed as disconnected. As shown in FIG. 5i, an inductor is disposed on the first branch, and no component is disposed on the second branch and the third branch, in other words, it may be considered that the second branch and the third branch are disposed as disconnected.

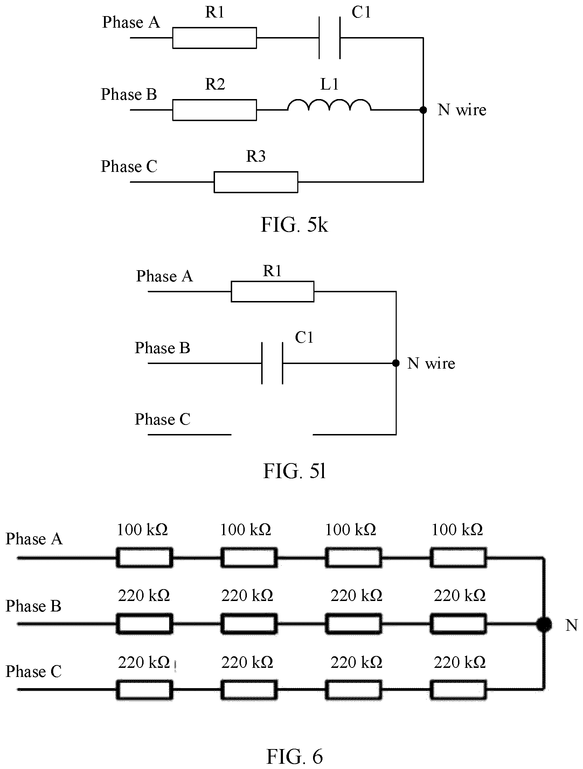

In some other embodiments of this application, as shown in FIG. 5j to FIG. 5l, components disposed on any two of the three branches may be different or not completely the same. For example, as shown in FIG. 5j, a capacitor is disposed on the first branch, an inductor is disposed on the second branch, and a resistor is disposed on the third branch. As shown in FIG. 5k, a resistor and a capacitor that are connected in series are disposed on the first branch, a resistor and an inductor that are connected in series are disposed on the second branch, and a resistor is disposed on the third branch. As shown in FIG. 5l, a resistor is disposed on the first branch, a capacitor is disposed on the second branch, and no component is disposed on the third branch, in other words, it may be considered that the third branch is disposed as disconnected.

In this application, components such as the resistor, the capacitor, and the inductor are used to construct the current imbalance branches between the N wire and the phase-A wire, the phase-B wire, and the phase-C wire. When the N wire is missed from connection, a voltage of the N wire deviates from a center point due to the current imbalance branches, and therefore three phase voltages are unequal. The three phase voltages are respectively voltages between the three phase wires and the neutral wire. When the N wire is normally connected, the voltage of the N wire is clamped by a voltage of a power grid, and the N wire cannot deviate from the center point through the current imbalance branches. Therefore, differences between every two of the three phase voltages are less than a threshold. In this case, after determining the three phase voltages AN, BN, and CN, the control circuit may calculate differences between every two of the three phase voltages AN, BN, and CN, that is, a difference between the phase voltage AN and the phase voltage BN, a difference between the phase voltage AN and the phase voltage CN, and a difference between the phase voltage BN and the phase voltage CN. When the N wire is normally connected, the voltage of the N wire does not deviate from the center point when clamped by the voltage of the power grid. Therefore, the differences between every two of the three phase voltages are less than a specified threshold. When the control circuit determines that the differences are less than the specified threshold, it is considered that the N wire is normal, and the inverter circuit can be started or run normally. When the N wire is faulty, the voltage of the N wire deviates from the center point due to the current imbalance branches. Therefore, the differences between every two of the three phase voltages are greater than a specified threshold. When the control circuit determines that any one of the differences is greater than the specified threshold, it is considered that the N wire is abnormally connected (including a missed connection or a wire disconnection), and an N-wire fault alarm signal is output. In addition, the N-wire fault alarm signal may indicate the power converter to send an alarm, or may be used to report an N-wire fault to a user.

In some embodiments of this application, when outputting the N-wire fault alarm signal, the control circuit may further control the power converter to shut down, to prevent an electric shock risk caused by the missed connection of the N wire.

In some embodiments of this application, to ensure compatibility of a three-phase three-wire alternating current power grid and a three-phase four-wire alternating current power grid, in other words, to enable the power converter provided in this application to be used in both the three-phase three-wire alternating current power grid and the three-phase four-wire alternating current power grid, the control circuit may specifically sample one phase voltage and two wire voltages of the power conversion circuit. Because any two wire voltages and any one phase voltage are known, the other wire voltage and the other two phase voltages may be obtained through calculation. In this way, the control circuit may obtain the three phase voltages through calculation based on the one phase voltage and the two wire voltages that are obtained through sampling. The wire voltage is a voltage between two phase wires.

In some other embodiments of this application, to ensure compatibility of a three-phase three-wire alternating current power grid and a three-phase four-wire alternating current power grid, in other words, to enable the power converter provided in this application to be used in both the three-phase three-wire alternating current power grid and the three-phase four-wire alternating current power grid, the control circuit may alternatively sample two phase voltages of the power conversion circuit and one wire voltage and that cannot be obtained through calculation based on vectors of the two phase voltages. Because any two phase voltages and one wire voltage that cannot be obtained through calculation based on vectors of the two phase voltages are known, the other phase voltage and the other two wire voltages may be obtained through calculation. In this way, the control circuit may obtain the three phase voltages through calculation based on the two phase voltages and the one wire voltage that are obtained through sampling.

FIG. 6 is an example diagram of a specific circuit structure of three branches in a power converter according to an embodiment of this application. As shown in FIG. 6, for example, when the power converter is used in a three-phase four-wire alternating current power grid, to construct current imbalance branches, four 100 kΩ resistors are connected in series on a first branch between a phase-A wire and an N wire, four 220 kΩ resistors are connected in series on a second branch between a phase-B wire and the N wire, and four 220 kΩ resistors are connected in series on a third branch between a phase-C wire and the N wire. A control circuit samples a wire voltage AC, a wire voltage BC, and a phase voltage CN.

For example, the power converter is connected to an AC 380 V alternating current power grid. When the N wire of the power converter is normally connected to the alternating current power grid, the control circuit may obtain a valid value 390 V of the wire voltage AC, a valid value 391 V of the wire voltage BC, and a valid value 227 V of the phase voltage CN. The control circuit calculates that a valid value of a phase voltage AN is 224 V, and a valid value of a phase voltage BN is 225 V. For example, when 5% of a rated voltage is set to a specified threshold, voltage differences between the phase voltage AN, the phase voltage BN, and the phase voltage CN each are less than 5% of the rated voltage. In this case, the control circuit may determine that the N wire is normally connected.

For example, the power converter is connected to an AC 380 V alternating current power grid. When the N wire of the power converter is not connected to the alternating current power grid, the control circuit may obtain a valid value 391 V of the wire voltage AC, a valid value 388 V of the wire voltage BC, and a valid value 257 V of the phase voltage CN. The control circuit calculates that a valid value of a phase voltage AN is 166 V, and a valid value of a phase voltage BN is 252 V. For example, when 5% of a rated voltage is set to a specified threshold, a voltage difference between the phase voltage AN and the phase voltage BN is greater than 5% of the rated voltage. In this case, the control circuit may determine that the N wire is abnormally connected, and the control circuit may output an N-wire fault alarm signal.

Based on a same inventive concept, this application further provides a photovoltaic system, including a photovoltaic array and the foregoing power converter in this application. The power converter is configured to: convert, into an alternating current, a direct current provided by the photovoltaic array, and output the alternating current to a power grid.

Based on a same inventive concept, an embodiment of this application further provides a detection method for a power converter. The method is applied to the power converter, and may be performed by a control circuit in the power converter.

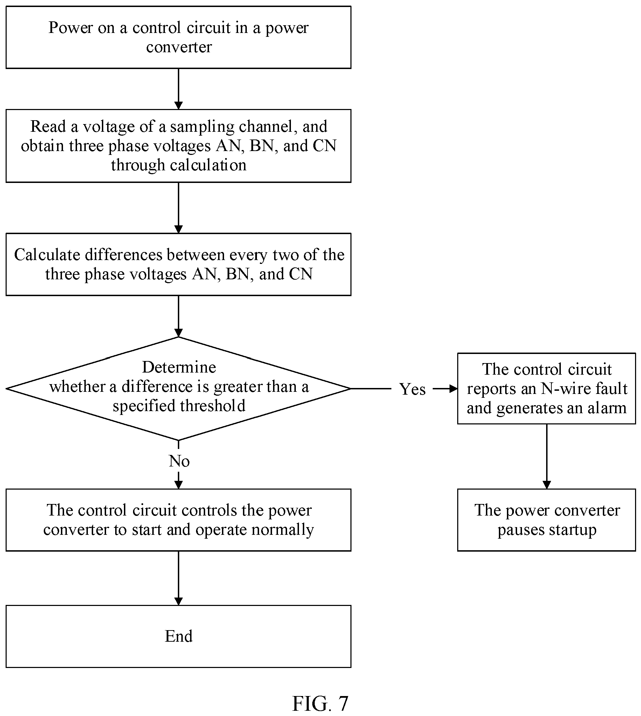

FIG. 7 is an example schematic flowchart of the detection method for the power converter according to this embodiment of this application. As shown in FIG. 7, the detection method provided in this embodiment of this application may be performed after a system is powered on, and specifically includes the following steps.

First, the control circuit in the power converter is powered on, completes operations such as initialization of the control circuit, and operates normally. The control circuit may be configured to drive an inverter circuit to operate.

Then, the control circuit reads a voltage of a sampling channel, and obtains three phase voltages AN, BN, and CN through calculation.

During specific implementation, two phase voltages and one wire voltage that cannot be obtained through calculation based on vectors of the two phase voltages may be obtained, and then the three phase voltages are obtained through calculation based on the two phase voltages and the one wire voltage. Alternatively, one phase voltage and two wire voltages are obtained, and then the three phase voltages are obtained through calculation based on the one phase voltage and the two wire voltages.

Then, differences between every two of the three phase voltages AN, BN, and CN, that is, a difference between the phase voltage AN and the phase voltage BN, a difference between the phase voltage AN and the phase voltage CN, and a difference between the phase voltage BN and the phase voltage CN, are calculated.

Further, whether there is a difference greater than a specified threshold is determined.

If the three differences are all less than the specified threshold, the control circuit controls the power converter to start and run normally. If there is a difference greater than the specified threshold, the control circuit reports an N-wire fault and generates an alarm, and the power converter pauses startup.

In the power converter and the detection method thereof that are provided in this application, the power converter includes a power conversion circuit and the control circuit. Three branches are formed between three phase wires of the power conversion circuit and an N wire, and the three branches form current imbalance branches. The power conversion circuit includes an inverter circuit and a filter circuit, and the three branches are located behind the filter circuit. When the N wire is normally connected, a voltage of the N wire does not deviate from a center point when clamped by a voltage of a power grid. Therefore, the differences between every two of the three phase voltages are less than the specified threshold. When the control circuit determines that the differences are less than the specified threshold, it is considered that the N wire is normal, and the inverter circuit can be started or run normally. When the N wire is faulty, a voltage of the N wire deviates from a center point due to the current imbalance branches. Therefore, the differences between every two of the three phase voltages are greater than the specified threshold. When the control circuit determines that a difference is greater than the specified threshold, it is considered that the N wire is abnormally connected, and an N-wire fault alarm signal is output. In the foregoing manner, it can be accurately determined that the N wire is abnormally connected.

It is clearly that a person skilled in the art can make various modifications and variations to the present invention without departing from the scope of the present invention. In this way, the present invention is intended to cover these modifications and variations provided that they fall within the scope of protection defined by the following claims and their equivalent technologies.

## Claims

1. A power converter, comprising a power conversion circuit and a control circuit, wherein
three branches are formed between three phase wires of the power conversion circuit and a neutral wire, the three branches comprise a first branch and a second branch, the first branch comprises at least one of a capacitor, a resistor, and an inductor, and a current of the first branch is different from a current of the second branch; and the power conversion circuit comprises an inverter circuit and a filter circuit, and the three branches are located behind the filter circuit; and
the control circuit is configured to: obtain differences between every two of three phase voltages output by the power converter, and output a neutral-wire fault alarm signal when any one of the differences is greater than a specified threshold, wherein the phase voltage is a voltage between one phase wire and the neutral line.

2. The power converter according to claim 1, wherein the control circuit is further configured to: sample two phase voltages of the power converter and one wire voltage that cannot be obtained through calculation based on vectors of the two phase voltages, and calculate the three phase voltages based on the two phase voltages and the one wire voltage, wherein the wire voltage is a voltage between two phase wires.

3. The power converter according to claim 1, wherein the control circuit is further configured to: sample one phase voltage and two wire voltages of the power converter, and calculate the three phase voltages based on the one phase voltage and the two wire voltages.

4. The power converter according to any one of claims 1 to 3, wherein the control circuit is further configured to:
when outputting the neutral-wire fault alarm signal, control the power converter to be shut down.

5. The power converter according to any one of claims 1 to 4, wherein the second branch comprises at least one of a capacitor, a resistor, and an inductor.

6. The power converter according to any one of claims 1 to 5, wherein the three branches further comprise a third branch, and a current of the third branch is different from the current of the first branch, and/or the current of the third branch is different from the current of the second branch.

7. The power converter according to claim 6, wherein the third branch comprises at least one of a capacitor, a resistor, and an inductor.

8. The power converter according to claim 6 or 7, wherein the first branch, the second branch, and the third branch each comprise the resistor, and resistance values of the resistors comprised in the first branch, the second branch, and the third branch are different.

9. The power converter according to any one of claims 1 to 8, wherein the power conversion circuit further comprises a surge protective device, and the three branches are located between the filter circuit and the surge protective device.

10. A detection method for a power converter, wherein the power converter comprises a power conversion circuit, three branches are formed between three phase wires of the power conversion circuit and a neutral wire, the three branches comprise a first branch and a second branch, the first branch comprises at least one of a capacitor, a resistor, and an inductor, and a current of the first branch is different from a current of the second branch; the power conversion circuit comprises an inverter circuit and a filter circuit, and the three branches are located behind the filter circuit; and
the detection method comprises:
obtaining differences between every two of three phase voltages output by the power converter, wherein the phase voltage is a voltage between one phase wire and the neutral line; and
outputting a neutral-wire fault alarm signal when any one of the differences is greater than a specified threshold.

11. The detection method according to claim 10, further comprising:
sampling two phase voltages of the power converter and one wire voltage that cannot be obtained through calculation based on vectors of the two phase voltages, and calculating the three phase voltages based on the two phase voltages and the one wire voltage, wherein the wire voltage is a voltage between two phase wires.

12. The detection method according to claim 10, further comprising:
obtaining one phase voltage and two wire voltages of the power converter, and calculating the three phase voltages based on the one phase voltage and the two wire voltages.

13. The detection method according to claim 10, further comprising:
controlling the power converter to be shut down when outputting the neutral-wire fault alarm signal.
